# EUROPEAN PATENT APPLICATION

(11) **EP 0 639 778 A2**
(43) Date of publication of application: **22.02.1995**
(21) Application number: 94305946.9
(22) Date of filing: 11.08.1994
(51) Int. Cl.: G01R 31/308, G01R 31/265

(54) **Fault based diagnosis of HBT-based circuits using electroluminescence**

(30) Priority: 16.08.1993 US 106737
(71) Applicant: TEKTRONIX, INC., Wilsonville, Oregon 97070-1000 (US)
(72) Inventor: Prasad, Jayasimha S., Tigard, Oregon 97223 (US)
(74) Representative: Burke, Steven David

(57) **Abstract**

Fault diagnosis of an HBT-based circuit using electroluminescence scans the circuit with a microscope coupled to a photodetector. The photodetector detects the light emitted by active elements of the circuit when powered and collected by the microscope. The light is converted into an electrical signal that may be displayed on an appropriate monitor for observation. The circuit may be powered with a steady source, a pulsing source or a gradually increasing source to detect which active elements are "on" or "off", which elements "latch up", and which elements "oscillate" contrary to expectations.

## Description

### Background of the Invention

The present invention relates to diagnosis of integrated circuits, and more particularly to fault based diagnosis of HBT-based circuits using electroluminescence to determine the activity of active elements in the circuits.

Typical diagnosis of integrated circuits is a time-consuming, manual operation. If the output of the integrated circuit is not correct, an engineer has to progressively cut circuitry within the integrated circuit to isolate the problem area through trial and error. In other words if the integrated circuit is a series of amplifiers, an engineer would work backwards from the output, progressively cutting out the amplifiers until the output from the current amplifier has a proper output. At that point the engineer can isolate the problem to the last stage of the integrated circuit that was cut out.

A heterojunction bipolar transistor (HBT) is one where the materials of the different portions of the transistor are different. Unlike silicon transistors where the base, emitter and collector are all silicon based, an HBT has, for example, an emitter of gallium aluminum arsenide (GaAlAs) and a base of gallium arsenide (GaAs). One problem with silicon-based transistors is that as electrons flow across the emitter-base junction, there is a reverse flow of holes across the same junction. HBTs however have a potential barrier across the emitter-base junction that suppresses hole injection, reducing the reverse flow of holes across the junction. The electron flow in a silicon transistor produces heat, since silicon is an indirect bandgap material. On the other hand HBTs are made of a direct bandgap material so that electrons, when energized into one state, return to the ground state in a single step, producing light energy.

An article in Applied Physics Letters 45 (5), 1 September 1984, by J.R. Hayes et al entitled "Electroluminescence from a heterojunction bipolar transistor" indicates that electroluminescence has been observed from the base of a GaAlAs/GaAs HBT. The article presents the conclusion that lack of luminescence from the GaAlAs emitter confirms that the gradient across the emitter-base junction significantly enhances hole confinement.

What is desired is a method of fault diagnosis of HBT-based circuits using electroluminescence to eliminate the prior trial and error manual cutting techniques.

### Summary of the Invention

Accordingly the present invention provides a method of fault diagnosis of HBT-based circuits using electroluminescence that examines each active element of an HBT circuit to determine its operation when energized. The HBT circuit is biased in a probe station under a microscope. The microscope in turn is optically coupled to a video camera capable of detecting the optical wavelengths corresponding to the electroluminescence emitted by the HBT devices. The output of the video camera is coupled to a television monitor for display. The HBT circuit is energized a d.c. power source as it would operate under normal conditions. A pulsed power source makes it easier to observe topology at room light to pinpoint the active elements, while a steady power source exercises the HBT circuit under normal operating conditions. The electroluminescence is observed to determine which active elements are on, which are off, which are latched and which are oscillating. By observing the activity of the active elements in the form of the emitted optical energy, an engineer can determine and isolate a region where potential problems exist.

The objects, advantages and other novel features of the present invention are apparent from the following detailed description when read in conjunction with the appended claims and attached drawing.

### Brief Description of the Drawing

Fig. 1 is a block diagram of a set-up for fault diagnosis of HBT-based circuits using electroluminescence according to the present invention.

Fig. 2 is a plan view of an HBT-based integrated circuit for a ring oscillator to be diagnosed for faults according to the present invention.

Fig. 3 is a plan view of a display of the ring oscillator of Fig. 2 when powered according to the present invention.

### Description of the Preferred Embodiment

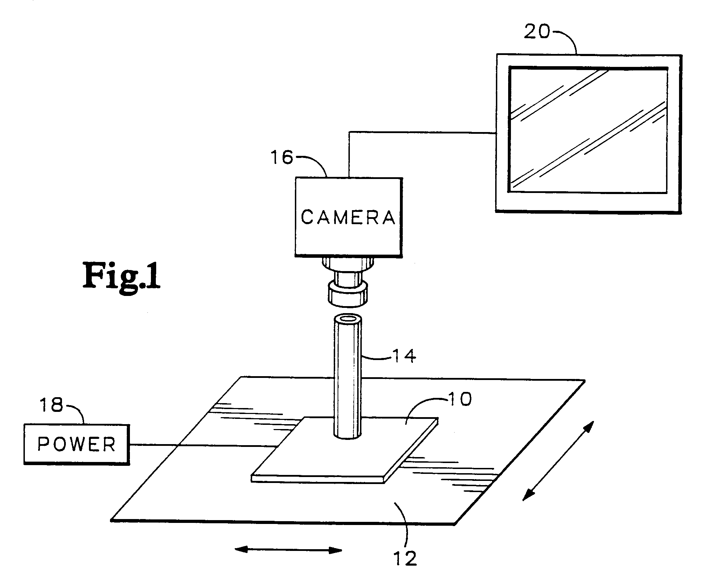

Referring now to Fig. 1 an HBT-based circuit **10** is shown mounted in a jig **12** of a probe station. A microscope **14** is mounted above the HBT-based circuit **10** and focused on the surface. A video camera **16** is mounted together with the microscope **14** so that optical energy from the microscope is picked up and detected by the video camera **16**. Since the electroluminescence emitted by the GaAlAs/GaAs HBT-based circuit **10** is in the infrared range, the detector in the video camera **16** is one that is sensitive to the expected electroluminescence. Either the microscope **14** or the jig **12** is movable in two dimensions so that the entire surface of the HBT-based circuit **10** may be scanned. An electrical energy source **18** is connected to the HBT-based circuit **10** to provide power to the circuit. Likewise the output of the video camera **16** in the form of an electrical video signal is coupled to a video monitor **20** to display what is viewed by the microscope **14**.

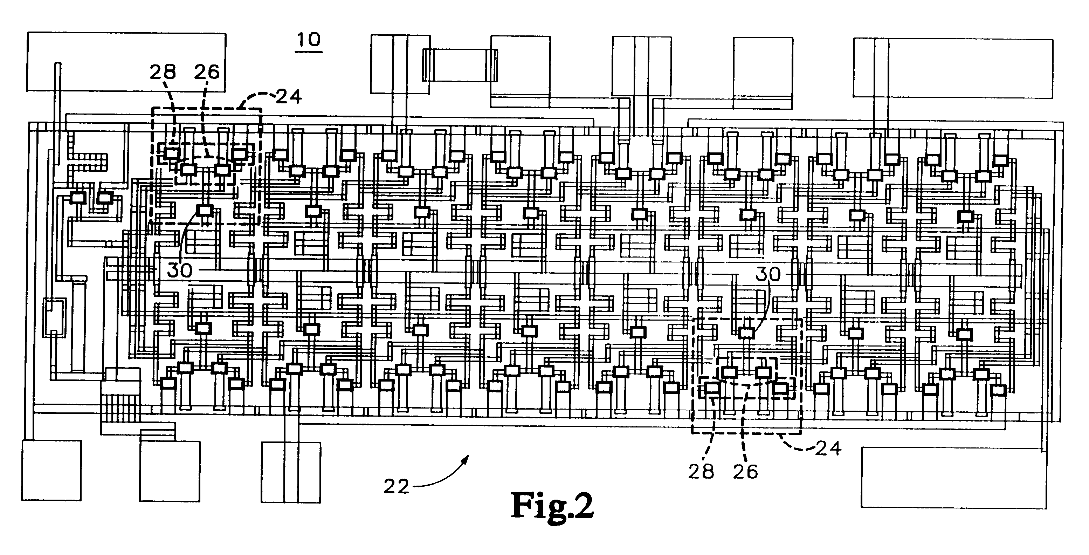

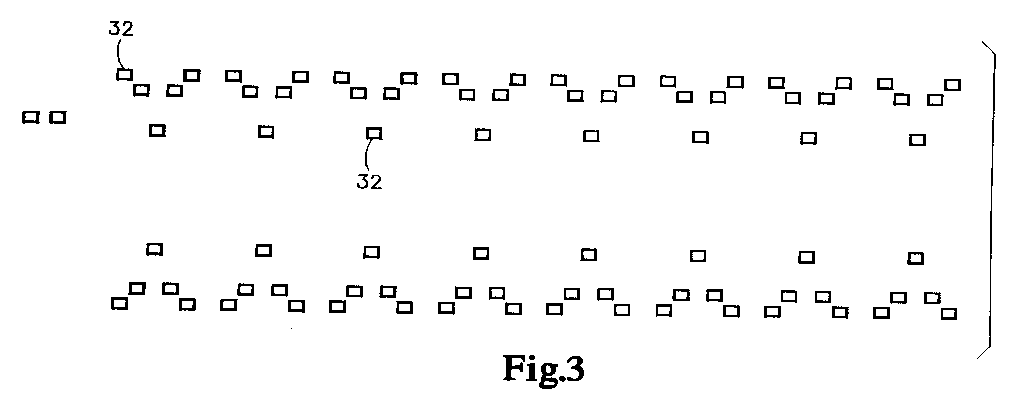

A typical HBT-based circuit **10** may be in the form of a ring oscillator **22**, which is shown as an integrated circuit in Fig. 2. Each stage **24** of the oscillator **22** has a differential input stage **26**, a differential output buffer stage **28** and a current source **30**. The differential output from one stage **24** is applied as the differential input to the next stage. When laid out on the HBT-based circuit **10**, each stage **24** forms a symmetrical arrangement of active elements. When energized by the energy source **18**, each active element becomes luminescent, providing a light pattern as shown in Fig. 3. Each light spot **32** represents an active element that is conducting ("on").

In operation electrical energy from the source **18** is applied to the HBT-based circuit **10** and the resulting electroluminescence pattern is observed on the video monitor **20** via the microscope **14** and video camera **16**. For optimum viewing room light is at a minimum to provide maximum contrast on the display. Where the active elements are conducting, light appears on the display, otherwise the display is dark. To observe the electroluminescence in brighter ambient light, the source **18** may be cycled to pulse the HBT-based circuit **10** so that the location of the active element on the circuit topology may be determined by the blinking of the active elements, which are then more apparent. To observe latching problems the source **18** is slowly increased so that the HBT-based circuit **10** is slowly powered up. As the HBT-based circuit **10** is powered up, circuits that are supposed to oscillate, such as astable multivibrators, may latch up instead of oscillating, while circuits that are supposed to latch up, such as bi-stable multivibrators, may oscillate instead of latching up. Observation in this manner allows an engineer to determine whether the HBT-based integrated circuit is operating properly, and if not where the problem is.

Thus the present invention provides a method of fault diagnosis for HBT-based circuits using electroluminescence to detect which active elements are "on" and which "off" during normal or stressed operation of the circuit, the conduction pattern of the active elements indicating whether the circuit is operating properly, and if not where the problem is.

## Claims

1. A method of fault diagnosis for an HBT-based circuit using electroluminescence comprising the steps of:
providing electrical power to the circuit;
observing active elements of the circuit with a microscope;
identifying which of the active elements are "on" by the light emitted; and
locating from the pattern of "on" active elements where faults in the circuit exist.

2. The method as recited in claim 1 wherein the observing step includes the steps of:
converting optical energy from the microscope into electrical energy using a photodetector; and
displaying the electrical energy as a video picture of the circuit on a monitor.

3. The method as recited in claim 2 wherein the observing step further includes the step of scanning the surface of the circuit by moving the circuit and microscope relative to each other in a controlled manner.

4. The method as recited in claim 1 wherein the providing step comprises the step of pulsing the electrical power so that the "on" active elements pulse to make them more readily visible in ambient light.

5. The method as recited in claim 1 wherein the providing step comprises the step of gradually bringing up the electrical power to see whether active elements that should oscillate latch up in a steady "on" condition.

6. An apparatus for fault diagnosis of an HBT-based circuit using electroluminescence comprising:
means for magnifying the surface of the circuit;
means for scanning the surface of the circuit so that all of the surface passes under the magnifying means; and
means for observing optical energy picked up by the magnifying means from active elements of the circuit when the circuit is energized so that the condition of the active elements as being either "on" or "off" is readily determinable.

7. The apparatus as recited in claim 6 wherein the magnifying means comprises a microscope focused on the surface of the circuit.

8. The apparatus as recited in claim 7 wherein the scanning means comprises a movable jig upon which the circuit is mounted, the jig being movable in such a manner that all of the surface of the circuit passes beneath the microscope.

9. The apparatus as recited in claim 7 wherein the observing means comprises:
means coupled to the microscope for converting the optical energy to electrical energy; and
means for displaying the electrical energy as a picture of the surface of the circuit.
